# EUROPEAN PATENT SPECIFICATION

(11) **EP 0 828 012 B1**
(45) Date of publication and mention of the grant of the patent: **19.12.2001**
(21) Application number: 97115559.3
(22) Date of filing: 08.09.1997
(51) Int. Cl.: C23C 16/00, B01D 1/00

(54) **Method for vaporizing liquid feed and vaporizer therefor**
Verfahren zur Verdampfung flüssiger Beschickungen und Verdampfer dafür
Procédé de vaporisation de liquides fournis à un vaporisateur et le vaporisateur correspondant

(30) Priority: 09.09.1996 JP 26026296
(43) Date of publication of application: 11.03.1998
(73) Proprietor: EBARA CORPORATION, Ohta-ku, Tokyo (JP)
(72) Inventor: Suzuki, Hidenao, Fujisawa-shi, Kanagawa-ken (JP); Horie, Kuniaki, Yamato-shi, Kanagawa-ken (JP); Nakada, Tsutomu, Yokohama-shi, Kanagawa-ken (JP); Murakami, Takeshi, Tokyo (JP)
(74) Representative: Wagner, Karl H., Dipl.-Ing.

(56) References cited:
- WO-A-97/31391
- Derwent Accession on Questel, week 9107, London: Derwent Publications Ltd., AN 91-049020, Class G 01 N; & JP 3-2558 A (EBARA SOGO KENKYUSH),

## Description

### BACKGROUND OF THE INVENTION

### Field of the Invention

The present invention relates in general to vaporizers used in chemical vapor deposition apparatus using a liquid feed material, and relates in particular to a vaporizer apparatus suitable for producing a vapor of a highly dielectric or ferroelectric material, such as barium or strontium titanate, for the purpose of making thin film devices.

### Description of the Related Art

In recent years, there has been a remarkable progress in circuit density of integrated circuit devices produced by the semiconductor industries, and intense development activities are underway in anticipation of gig-bit order DRAMs replacing the prevailing meager-bit order DRAMs of today. Dielectric thin film materials used to make high capacitance devices necessary for producing DRAMs have, in the past, included silicon oxide or silicon nitride films of dielectric constant less than 10, tantalum pentaoxide (Ta₂O₅) films of dielectric constant about 20; however, newer materials such as barium titanate (BaTiO₃) or strontium titanate (SrTiO₃) or mixtures of these compounds appear to be more promising. Promising also are even higher dielectric materials such as lead-zinc-titanate (PZT), lead-lithium-zinc-titanate (PLZT) and Y1.

Of the various methods of making such thin films, prospects are particularly bright for the chemical vapor deposition (CVD) process, in which it is necessary that a feed gas must ultimately be supplied in a steady gas stream to a substrate disposed in a deposition chamber. The feed gas is derived by heating a liquid mixture, produced by dissolving in some organic solvent (for example, Tetrahydrofuran (THF)) such materials as Ba(DPM)₂ or Sr(DPM)₂ which is solid at normal temperature, to stabilize the vaporization characteristics.

Some known examples of vaporizer apparatus include those that atomize the liquid feed material through spay nozzles or ultrasonic transducers, and the atomized mist is delivered to a high temperature zone to convert the mist to a gaseous species, which is embodized as, for example, a vaporizing chamber surrounded by feed heater plates, or a porous heater member to improve the vaporization efficiency by increasing a contact area between the atomized mist and the heater member.

However, it is extremely difficult to stably vaporize such highly dielectric and ferroelectric materials mentioned above. This is because for these materials, ① the vaporization and decomposition temperatures are close; ② the vaporization temperature for the liquid feed material is different from that for the organic solvent; and ③ the vapor pressures are very low in general.

The problems in such conventional techniques arise from the fact that the atomized mist particles are swept in its own stream of vaporized gas or carrier gas (used to transport the atomized mist particles), and it is difficult for the mist particles to properly dwell on the heating surfaces, even if the flow passages are constricted, resulting that the heat transfer from the heating surfaces to the atomized mist particles is poor, and leading ultimately to low efficiency in the vaporizer. Under such a condition, the mist particles tend to stay for a long time in an intermediate temperature zone of the vaporizer, between the vaporizing temperatures of the liquid feed material and the organic solvent, so that the solvent is selectively vaporized, leaving behind a degraded feed gas suffering from precipitation of critical constituents or inconsistency in the composition.

Attention is drawn to the document Derwent Accession on Questel, week 9107, London: Derwent publications Ltd, AN 91-049020, Class G 01 N; & JP 3-2558 A, which discloses a process and apparatus for measurement of micro particles, in which a liquid is gasified and the particles are charged by UV radiation and detected.

In accordance with the present invention a method for vaporizing a liquid feed material, as set forth in claim1, and a vaporizer apparatus for producing a vapour of a liquid feed material, as set forth in claim 5 is provided. Preferred embodiments of the invention are disclosed in the dependent claims.

### SUMMARY OF THE INVENTION

It is an object of the present invention to provide a method and an apparatus capable of obtaining a high vaporization efficiency by efficiently guiding atomized mist particles of a liquid feed material to the surface of a heater device, as well as preventing unintended deposition of the feed material within the vaporization process in order to stably supply the vapor of the feed material to a vapor deposition process.

The object has been achieved in a method for vaporizing a liquid feed material for use in vapor phase reaction processes comprising the steps of: forming atomized particles having electrical charges; guiding the atomized particles to a feed heater in an electrical force field, and adsorbing the atomized particles on the feed heater by electrostatic attraction forces so as to facilitate a process of vaporization of the liquid feed material.

Accordingly, the atomized particles having electrical charges of the liquid feed material are transported preferentially towards the feed heater separate from the flow of the carrier gas and vapor of the liquid feed material, so that they can be adsorbed and held on the surface of the feed heater. Therefore, the proportion of the unvaporized atomized feed which can be swept downstream by the (carrier) gas flow is reduced so that the mist particles are effectively and efficiently vaporized. Furthermore, because the charged mist particles tend to distance themselves from each other, the mist particles distribute themselves widely over the heater surface to effectively utilize the large surface area of the feed heater.

An aspect of the method is that the atomized particles are formed by an atomizing device, and are imparted with electrical charges through contact with charged particles produced in an electrical discharge process.

Another aspect of the method is that the liquid feed material is introduced at a tip end of a feed nozzle, and the atomized particles are produced through an electrostatic atomization process generated by a high voltage applied between the feed nozzle and the feed heater.

The object has been achieved in a vaporizer apparatus for producing a vapor of a liquid feed material for use in vapor phase reaction processes, comprising: atomizing means for forming electrically charged atomized particles of the liquid feed material; a feed heater maintained at a temperature higher than a vaporization temperature of the liquid feed material; guiding means for guiding the electrically charged particles to the feed heater by providing an electrical force field.

An aspect of the vaporizer apparatus is that the atomizing means comprise an atomizer; an electrode means, having a sharp electrode tip, disposed in a flow stream of atomized particles; and charging means for imparting electrical charges to atomized particles produced in cooperation with an application of a high voltage between the sharp electrode tip and the feed heater so as to generate an electrical discharge.

Another aspect of the vaporizer apparatus is that the atomizing means comprise a feed nozzle; and a charging means for imparting electrical charges to the liquid feed material held in the feed nozzle by applying a high voltage between the feed nozzle and the feed heater so as to produce electrically charged atomized liquids through an electrostatic atomization process.

### BRIEF DESCRIPTION OF THE DRAWINGS

Figure 1 is a cross sectional view of a first embodiment of the vaporizer apparatus of the present invention.

Figure 2 is a cross sectional view of a second embodiment of the vaporizer apparatus of the present invention.

Figure 3 is a cross sectional view of a variation of the first embodiment of the vaporizer apparatus of the present invention.

Figure 4 is cross sectional view of a variation of the second embodiment of the vaporizer apparatus of the present invention.

### DESCRIPTION OF THE PREFERRED EMBODIMENTS

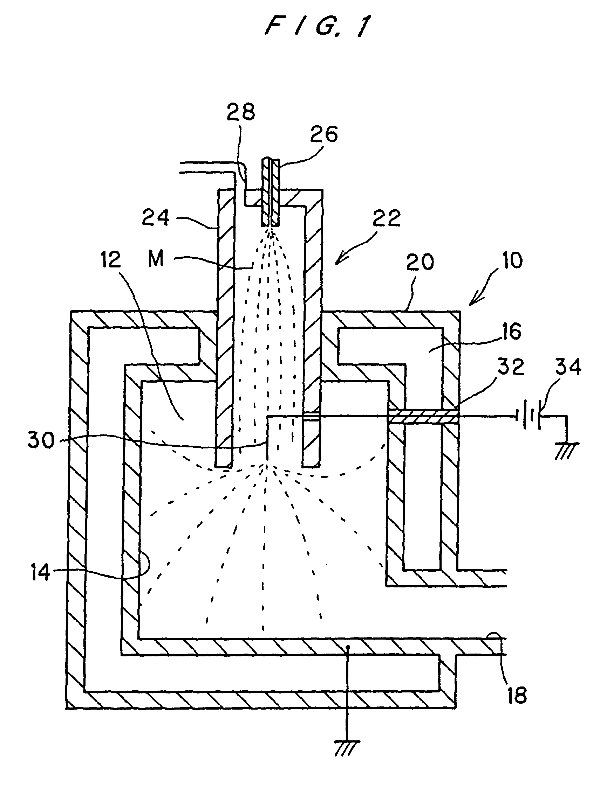

Figure 1 shows a first embodiment of the vaporizer apparatus of the present invention. The vaporizer apparatus comprises a hermetic vaporization chamber 12 including a vessel 10, made of a conductive material. The wall section 14 of the vessel 10 is heated with a jacket heater 16, having a thermal medium such as hot oil flowing in the interior space, to maintain the temperature of the wall section 14 at a certain temperature above the vaporization temperature of the liquid feed material. An exhaust port 18 is provided on the side surface of the vessel 10 near the bottom section, for communicating normally with a vacuum pump by way of a processing chamber such as a film deposition chamber.

The ceiling plate 20 of the vessel 10 includes an atomizing section 22 for spraying atomized liquid feed material into the vaporization chamber 12. The atomizing section 22 comprises an atomizer 26 and a carrier gas inlet 28 which are disposed above a cylindrical member 24, made of an insulating material, opening to the interior space of the vaporization chamber 12. The atomizer 26 is a known device, comprising a spray nozzle with an integral ultrasonic transducer, and is connected to a liquid feed supply source through a flow volume control device. The carrier gas inlet 28 is connected to an inert gas source, such as Ar, N₂ or the like.

The vessel 10 housing the vaporization chamber 12 is electrically grounded. In the vicinity of the outlet of the cylindrical member 24, a sharp tipped electrode member 30 for being applied with a high voltage is disposed in such a way to locate the sharp tip portion of the electrode 30 parallel with the feed stream. The electrode 30 is electrically connected to an external high voltage source 34, through a hermetic cable terminal 32, applicable of several tens of KV to hundreds of KV voltage.

The operation of the vaporizer apparatus will be explained in the following. Atomized particles M of the liquid feed material, produced by the atomizer 26, are supplied to the interior space of the cylindrical member 24, while a carrier gas such as Ar or N₂ gas is introduced through the gas inlet 28. A high voltage of several tens of KV to hundreds of KV is applied between the tip portion of the electrode 30 and the feed heater (wall section) 14, and therefore, a corona discharge is generated in the carrier gas environment. The carrier gas molecular ions (for example, Ar ions) produced by the corona discharge collide with the atomized particles M to impart electrical charges to the particles M. The charged particles M, under the influence of the electrical force field, are accelerated towards the grounded feed heater 14. The result is that negligible portion of the atomized particles M is swept into the carrier gas stream, and most of the particles are delivered to the feed heater 14.

When the charged particles M arrive at the surface of the feed heater 14, not all the electrical charges are lost upon contact with the wall surface, and the charges remaining in the particles serve to provide electrostatic attraction between the feed heater 14 and the charged particles M, which are adsorbed onto the surface of the feed heater 14. The attraction force tends to press the charged particles M onto the heater to increase the contacting area of the atomized particles M with the surface of the feed heater 14, thereby improving heat transfer efficiency to accomplish instantaneous vaporization of the heated particles M.

During this process, the thermal medium is circulated inside the jacket heater 16 by a thermal media circulation unit (not shown) having at least a heating device such as an electrical heater and an actuating device such as a pump. Temperature sensor for control of the temperature of the thermal medium may be located on an external pipe or directly on the interior of the jacket heater 16 of the vaporizer apparatus.

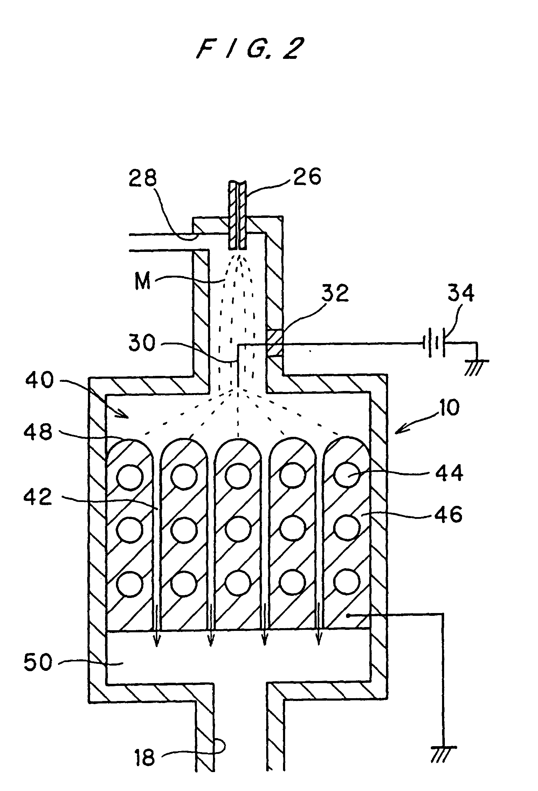

Figure 2 shows a second embodiment comprising a vessel 10 made of an insulating material and a feed heater including a multi-layer-plate structure 40 stacked each other with a fine spacing 42 between the plates. The multi-plate structure 40 is comprised of a number of electrically conductive plates 46, each having an oil passage 44 at the core, separated by a fine spacing 42 of less than 0.3 mm. The surface temperature of the plates 46 is about the same as that of the circulating oil. The fine spacing 42 acts as the vapor passage for the multi-plate structure 46, which is constructed so that the top end surface 48 of the plate 46 has a semi-circular shape, thus, the spacing of the plates 46 are wider at the top than at the bottom of the structure 46. The bottom outlet section of the fine spacings (vapor passage) 42 communicates with the exhaust port 18 through the bottom space 50.

In this vaporizer apparatus, the electrically charged particles M are accelerated towards the plates 46 acting as the feed heater under the influence of the electrical force field, and are attracted and adsorbed to the top end surface 48 of the plates 46. The adsorbed particles M are instantly vaporized by the heat conducted from the plate 46, and the vaporized gas is transported to a downstream film deposition chamber. In this case, because the shape of the top end surface 48 of the plate 46 is semi-circular, adsorption surface is set larger than in the case with a flat top surface, and a smooth entry flow of the vaporized liquid into the vapor flow passage 42 is facilitated. The width of the vapor passage 42 itself does not need to be uniform from top to bottom, and may be designed so that the downstream spacing becomes narrower (than the top spacing) towards the vapor exit section.

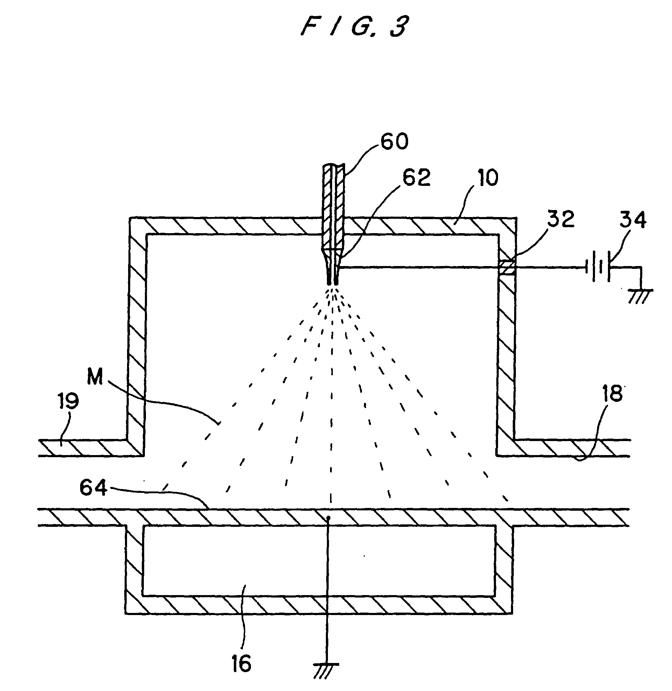

Figure 3 is a variation of the first embodiment vaporizer apparatus. The embodiment incorporates an electrostatic atomizer in place of an ultrasonic atomizer in the atomizer section 22 of Figure 1. In this case, electrostatic atomizing is performed by an electrically conductive nozzle 62 provided at the tip of an insulator pipe 60 for flowing a liquid feed material. A carrier gas inlet 19 is provided on the wall of the vessel 10 oppsosite to the exhaust port 18.

The vaporizer apparatus operates as follows. A liquid feed material is introduced into the insulator pipe 60 so that a liquid surface will appear at the exit tip of the nozzle 62. A high voltage of the order of several KV to several tens of KV from a high voltage supply is applied between the nozzle 62 and the bottom plate (liquid feed heater) 64, which is grounded, to impart electrical charges to the liquid feed material. Because of the presence of a strong electrical field at the outlet of the nozzle 62, the liquid feed material at the exit tip of the nozzle 62 loaded with electrical charges, when the electromotive force exceeds the liquid surface tension, becomes unstable and explodes out to produce atomized and charged particles M. The particle size can be altered over a range of several µm to several hundred µm by varying the electrical field strength. The charged particles M are efficiently vaporized as in the case of the first embodiment.

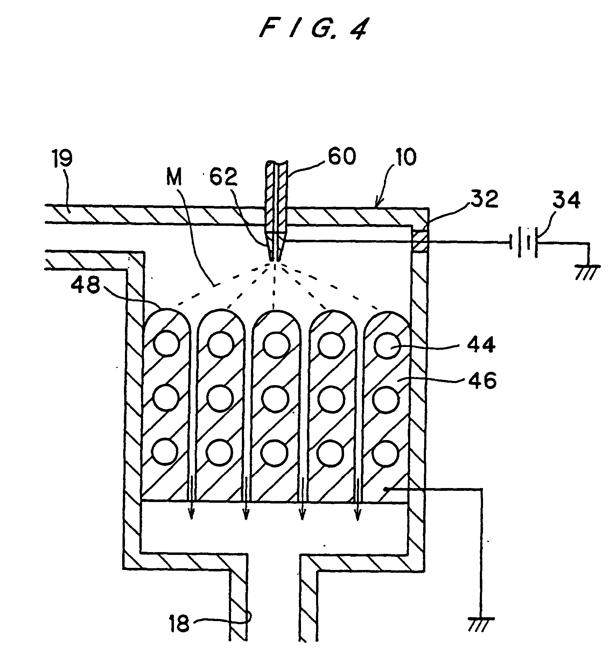

Figure 4 shows an application of the electrostatic atomizer to the vaporizer apparatus shown in Figure 2, and since the effects and operations are similar to the second embodiment vaporizer apparatus, their explanations will be omitted.

According to the method and apparatus presented, because the atomized mist particles are electrically charged and guided by an electrical force field to be adsorbed onto a surface of the heater, the number of unconverted mist particles which are carried away in the carrier gas without reaching the surface of the feed heater are reduced. Thus, the conversion process is made more efficient so as to supply a high quality vapor to carry out a stable vapor deposition process at the downstream of the vaporizer apparatus.

According to its broadest aspect, the invention relates to a method for vaporizing a liquid feed material for use in chemical vapor deposition processes comprising the steps of: forming atomized particles having electrical charges; guiding said atomized particles to a feed heater and adsorbing said atomized particles on said feed heater.

## Claims

1. A method for vaporizing a liquid feed material for use in chemical vapor deposition processes comprising the steps of: forming atomized particles having electrical charges; guiding said atomized particles to a feed heater in an electrical force field, and adsorbing said atomized particles on said feed heater by electrostatic attraction forces so as to facilitate a process of vaporization of said liquid feed material.

2. Amethod according to claim 1, wherein said atomized particles are formed by an atomizing device, and are imparted with electrical charges through contact with charged particles produced in an electrical discharge process.

3. A method according to claim 1, wherein said liquid feed material is introduced at a tip end of a feed nozzle, and said atomized particles are produced through an electrostatic atomization process generated by a high voltage applied between said feed nozzle and said feed heater.

4. A method according to claim 3, wherein said high voltage is between several kilo-volts to hundreds of kilo-volts.

5. A vaporizer apparatus for producing a vapor of a liquid feed material for use in chemical vapor deposition processes, comprising: atomizing means for forming electrically charged atomized particles of said liquid feed material; a feed heater maintained at a temperature higher than a vaporization temperature of said liquid feed material; guiding means for guiding said electrically charged particles to said feed heater by providing an electrical force field.

6. A vaporizer apparatus according to claim 5, wherein said atomizing means comprise an atomizer; an electrode means, having a sharp electrode tip, disposed in a flow stream of atomized particles; and discharge generating means for generating an electrical discharge around said sharp electrode tip with an application of a high voltage between said sharp electrode tip and said feed heater.

7. A vaporizer apparatus according to claim 5, wherein said atomizing means comprise a feed nozzle; and a charging means for imparting electrical charges to said liquid feed material held in said feed nozzle by applying a high voltage between said feed nozzle and said feed heater so as to produce electrically charged atomized liquids through an electrostatic atomization process.

8. An apparatus according to claim 7, wherein said high voltage is between several kilo-volts to several tens of kilo-volts.

## Patentansprüche

1. Verfahren zum Verdampfen eines flüssigen Zufuhrmaterials (feed material) für den Einsatz in chemischen Dampfabscheidungsprozessen, das die Folgenden Schritte aufweist: Bilden von versprühten bzw. zerstäubten Teilchen (atomized particles) mit elektrischen Ladungen; Führen der zerstäubten Teilchen zu einer Zufuhrheizung in einem elektrischen Kraftfeld, und Absorbieren der zerstäubten Teilchen auf die Zufuhrheizung durch elektro-statische Anziehungskräfte, um so einen Prozeß zum Verdampfen des flüssigen Zufuhrmaterials zu erleichtern.

2. Ein Verfahren gemäß Anspruch 1, wobei die zerstäubten Teilchen durch eine Zerstäubungsvorrichtung gebildet werden, und durch Kontakt mit geladenen Teilchen, die in einem elektrischen Entladungsprozeß erzeugt werden, mit elektrischen Ladungen belegt werden.

3. Ein Verfahren gemäß Anspruch 1, wobei die flüssige Zufuhrmaterial am oberen Ende einer Zufuhrdüse eingeführt wird, und die zerstäubten Teilchen durch einen. elektro-statischen Zerstäubungsprozeß erzeugt werden, und zwar durch eine Hochspannung, die zwischen der Zufuhrdüse und der Zufuhrheizung angelegt wird.

4. Ein Verfahren gemäß Anspruch 3, wobei die Hochspannung zwischen einigen Kilovolt und Hunderten von Kilovolt liegt.

5. Verdampfungsvorrichtung zum Erzeugen eines Dampfes eines flüssigen Zufuhrmaterials für den Einsatz in chemischen Dampfabscheidungsprozessen, die Folgendes aufweist: Zerstäubungsmittel zum Bilden von elektrisch geladenen, zerstäubten Teilchen des flüssigen Zufuhrmaterials; eine Zufuhrheizung, die bei einer Temperatur gehalten wird, die höher ist als die Verdampfungstemperatur des flüssigen Zufuhrmaterials; Führungsmittel zum Führen der elektrisch geladenen Teilchen zu der Zufuhrheizung zum Vorsehen eines elektrischen Kraftfelds.

6. Eine Verdampfungsvorrichtung gemäß Anspruch 5, wobei die Zerstäubungsmittel Folgendes aufweisen: einen Zerstäuber; Elektrodenmittel, die eine scharfe Elektrodenspitze haben, die in den Strömungsfluß der zerstäubten Teilchen befindlich ist; und Entladungserzeugungsmittel zur Erzeugung einer elektrischen Entladung um die scharfe Elektrodenspitze herum, und zwar durch ein Anlegen einer Hochspannung zwischen der scharfen Elektrodenspitze und der Zufuhrheizung.

7. Verdampfungsvorrichtung gemäß Anspruch 5, wobei die Zerstäubungsmittel Folgendes aufweisen: eine Zufuhrdüse; und Ladungsmittel zum Zuführen von elektrischen Ladungen zu dem flüssigen Zufuhrmaterial, das in der Zufuhrdüse gehalten wird, und zwar durch Anlegen von Hochspannung zwischen der Zufuhrdüse und der Zufuhrheizung, um so elektrisch geladene, zerstäubte Flüssigkeiten durch einen elektro-statischen Zerstäubungsprozeß zu erzeugen.

8. Eine Vorrichtung gemäß Anspruch 7, wobei die Hochspannung zwischen einigen Kilovolt und mehreren Zehn Kilovolt liegt.

## Revendications

1. Procédé pour vaporiser un matériau d'alimentation liquide destiné à être utilisé dans des procédés de dépôt chimique en phase vapeur, comprenant les étapes consistant à : former des particules atomisées ayant des charges électriques; guider lesdites particules atomisées en direction d'un dispositif de chauffage du matériau d'alimentation dans un champ de force électrique, et adsorber lesdites particules atomisées dans ledit dispositif de chauffage du matériau d'alimentation au moyen de forces d'attraction électrostatiques de manière à faciliter un processus de vaporisation dudit matériau d'alimentation liquide.

2. Procédé selon la revendication 1, selon lequel lesdites particules atomisées sont formées par un dispositif d'atomisation et reçoivent des charges électriques sous l'effet de leur contact avec des particules chargées produites lors d'un processus de décharge électrique.

3. Procédé selon la revendication 1, selon lequel ledit matériau d'alimentation liquide est introduit au niveau d'une pointe d'extrémité d'une buse d'alimentation, lesdites particules atomisées sont produites au moyen d'un processus d'atomisation électrostatique provoqué par une haute tension appliquée entre ladite buse d'alimentation et ledit dispositif de chauffage du matériau d'alimentation.

4. Procédé selon la revendication 3, selon lequel ladite haute tension est comprise entre quelques kilovolts et quelques centaines de kilovolts.

5. Dispositif de vaporisation pour produire une vapeur d'un matériau d'alimentation liquide destiné à être utilisé dans des procédés de dépôt chimique en phase vapeur, comprenant : des moyens d'atomisation pour former les particules atomisées chargées électriquement dudit matériau d'alimentation liquide; un dispositif de chauffage du matériau d'alimentation maintenu à une température supérieure à une température de vaporisation dudit matériau d'alimentation liquide; des moyens de guidage pour guider lesdites particules électriquement chargées jusqu'audit dispositif de chauffage du matériau d'alimentation par application d'un champ de force électrique.

6. Dispositif de vaporisation selon la revendication 5, dans lequel lesdits moyens d'atomisation comprennent un atomiseur; des moyens formant électrode comportant une pointe acérée d'électrode, disposée dans un courant d'écoulement de particules atomisées; et des moyens de production d'une décharge pour produire une décharge électrique autour de ladite pointe acérée d'électrode avec application d'une haute tension entre ladite pointe acérée d'électrode et ledit dispositif de chauffage du matériau d'alimentation.

7. Dispositif de vaporisation selon la revendication 5, dans lequel lesdits moyens d'atomisation comprennent une buse d'alimentation; et des moyens de charge pour appliquer des charges électriques audit matériau d'alimentation liquide retenu dans ladite buse d'alimentation par application d'une haute tension entre ladite buse d'alimentation et ledit dispositif de chauffage du matériau d'alimentation de manière à produire des liquides atomisés chargés électriquement, au moyen d'un processus d'atomisation électrostatique.

8. Dispositif de vaporisation selon la revendication 7, dans lequel ladite haute tension est comprise entre quelques kilovolts et quelques dizaines de kilovolts.
